Europäisches Patentamt

European Patent Office

Office européen des brevets

⑩

(11) Publication number: **0 091 163**
**B1**

(12) **EUROPEAN PATENT SPECIFICATION**

(45) Date of publication of patent specification: **25.11.87**

(21) Application number: **83200445.1**

(22) Date of filing: **30.03.83**

(51) Int. Cl.⁴: **G 03 F 7/10, H 01 J 9/227**

(54) **Positive-working photoresist composition and method for forming a light-absorbing matrix in a color CRT structure.**

(30) Priority: **02.04.82 US 364949**

(43) Date of publication of application:
**12.10.83 Bulletin 83/41**

(45) Publication of the grant of the patent:
**25.11.87 Bulletin 87/48**

(84) Designated Contracting States:
**DE FR GB NL**

(56) References cited:
**FR-A-2 308 950**
**GB-A-1 113 203**
**US-A-2 927 021**
**US-A-3 169 065**
**US-A-3 620 735**

(73) Proprietor: **North American Philips Corporation**
**100 East 42nd Street 9th Floor**
**New York, N.Y. 10017 (US)**

(72) Inventor: **Lambert, Robert Lincoln**
**c/o INT. OCTROOIBUREAU B.V. Prof. Holstlaan 6**
**NL-5656 AA Eindhoven (NL)**
Inventor: **Nagel, Judy Ann**
**c/o INT. OCTROOIBUREAU B.V. Prof. Holstlaan 6**
**NL-5656 AA Eindhoven (NL)**
Inventor: **Bergamo, Robert Leo**
**c/o INT. OCTROOIBUREAU B.V. Prof. Holstlaan 6**
**NL-5656 AA Eindhoven (NL)**

(74) Representative: **Auwerda, Cornelis Petrus et al**
**INTERNATIONAAL OCTROOIBUREAU B.V. Prof.**
**Holstlaan 6**
**NL-5656 AA Eindhoven (NL)**

Courier Press, Leamington Spa, England.

# 0 091 163

**Description**

The invention relates to a positive-working photoresist composition, and to a method of providing a cathode ray tube screen as claimed in Claims 1 and 12.

Color cathode ray tubes (CRT) such as employed in color television applications generally have a patterned screen comprising repetitive groups of phosphor material which may be in the form of bars, stripes or dots. Thus, the well known shadow mask tube construction may be employed wherein the screen pattern is in the form of dots formed of selected cathodo luminescent phosphors which phosphoresce by predetermined electron excitation, to produce additive primary hues in order to produce the desired colour emanations.

This electron excitation of the phosphor dots is achieved by focusing the electron beams from three electron guns through a shadow mask positioned in a spaced manner from the screen. The shadow mask is provided with apertures each of which is perceptively related to a specific grouping of similar shaped dots in the screen structure to enable selected electron beams traversing the apertures to impinge on the proper phosphor dots on the screen. These dots are generally separated by relatively small interstitial spacings in order to enhance colour purity by reducing the possibility of electronic excitation of adjacent dots.

In order to enhance the brightness, colour purity and contrast of the resulting colour screen image the interstitial spacing between the phosphor dots, stripes or bars is generally occupied by an opaque light-absorbing material or a matrix which generally is a black pigmented material.

Hedler et al, U.S.—A—3,658,530 describes a frequently employed method for providing such a light-absorbing matrix on a screen of a colour CRT.

U.S.—A—3,620,735 describes a photosensitive composition comprising, in a mixture in water, a polymeric binder such as polyvinyl alcohol, a ferric salt and an inhibitor for the ferric salt, for example ammonium ferric oxalate.

According to the method described in the U.S.—A—3,658,530 the interior surface of the screen is coated with a thin uniform layer of a polyvinyl alcohol solution made photosensitively active with a hexavalent chromate material. The thus coated screen is then exposed to light through the apertures of a pattern mask thereby polymerizing the exposed portions of the photosensitive polyvinyl alcohol layer. The exposed coating is then soaked with water to remove the unexposed and resultant unpolymerized areas of the polyvinyl alcohol layer to thereby provide a plurality of repetitive elements of polymerized polyvinyl alcohol dots separated by an interstitial pattern or web of substantially clear glass.

This panel is then coated with an opaque colloidal suspension of graphite and then dried to form an opaque graphite film, the opaque graphite film being present both on the bare glass and on the polymerized polyvinyl alcohol dots.

The panel is then treated with a hydrazo-reducing agent capable of degrading the polymerized polyvinyl alcohol dots. By this treatment the light polymerized polyvinyl alcohol pattern dots are degraded and the graphite film positioned on these dots is loosened from the screen.

The screen is then rinsed to remove the loosened degraded polyvinyl alcohol dots and the associated graphite and leaving thereby a multitude of clear glass windows surrounded by an opaque interstitial web or matrix of graphite.

The resultant window patterned screen is then· dried and by means of conventional screening techniques the phosphors are applied to the respective window areas and a cathode luminescent screen is formed.

This method has the drawbacks in that the large number of steps in the process which requires manual handling provides opportunities for potential handling errors and inclusion of dirt in the screen.

Further the use of the hexavalent chromium provides a potential pollution problem as the amounts of this material and the hydrazo-reducing agents materials permitted in the effluent are extremely small.

Similar methods of forming the light absorbing opaque matrix are disclosed in Speigel, U.S.—A—3,822,454, particularly column 9, lines 20—60; and Bergamo et al U.S.—A—4,245,019, particularly column 4, line 37—column 5, line 60 where a hydrogen peroxide solution is employed as the degrading agent.

While the use of hydrogen peroxide is advantageous over the hydrazide degrading solutions of the Hedler et al patent as being less hazardous, the use of hydrogen peroxide solutions are still undesirable as the hydrogen peroxide solutions are also hazardous and they must be closely controlled both for safety's sake and for proper image development. In addition, the presence of undecomposed hydrogen peroxide in the manufacturing plant effluent will reoxidize any trivalent chromium (produced by a previous light exposure process) to hexavalent chromium compounds.

An object of this invention is to provide photoresist compositions which eliminate or reduce the use of hexavalent chromates and other potentially hazardous reagents.

Another object of this invention is to provide an improved composition for use in forming a light-absorbent opaque matrix in the production of color cathode ray tubes.

Still another object of this invention is to provide a method of forming a light-absorbing opaque matrix on the screens of color cathode ray tubes in which there is a substantial reduction of steps.

These and other objects of the invention will be apparent from the description that follows.

According to one aspect of the invention some of these objects are achieved by a new and novel positive-working photo-resist composition which composition contains no hexavalent chromium or other

2

hazardous material but instead comprises a mixture in water of either ammoniumtrioxalatoferrate or ferric ammonium tricitrate, 85 to 99% hydrolyzed polyvinyl alcohol, an inorganic ferric salt such as ferric nitrate or ferric sulfate, and a diol such as 1,4-butanediol, 1,5-pentanediol and 1,4-pentanediol.

Unlike the hexavalent chromium activated polyvinyl alcohol compositions the instant composition is a positive-working resist composition.

The photosensitive composition of the invention is employed to form a positive photoresist in the following manner. A thin layer of the composition is applied to a substrate. The thin layer is then dried at room temperature in order to remove a sufficient amount of water to cause the layer to become immobile. The thin layer is then exposed to radiation within the range of 302 nm to approximately 488 nm in a desired pattern to cause the exposed areas to become water soluble. The layer thus selectively exposed is then heated at about 35°C to 49°C (95°F to 120°F) to remove the remainder of the water and to cause the unexposed areas of the layer to become water insoluble. Finally, the exposed portions of the layer are removed by developing the layer with water.

While not being bound to the following explanation it is believed that the mechanism by which this photosensitive composition functions is as follows: If the composition is thoroughly dry the $Fe^{+++}$ of the ferric nitrate dissolved only its water of crystallization will react with the hydroxyl groups of the polyvinyl alcohol to form a complex which becomes insoluble through crosslinking of these molecule chains through oxygen-iron-oxygen bridges. These bridges may be broken and the complex rendered soluble by exposure to dilute organic acids such as acetic, citric or oxalic acids.

However, when a stabilized acid salt such as a ferric ammonium oxalate or a ferric ammonium citrate is employed it releases the acid at a sufficiently slow rate to make practical use for it in a photosensitive composition. The usefulness of these ammonium ferric salts in photosensitive compositions is based on the ability of these salts to react only very slowly to resolubilize the ferric ion polyvinyl alcohol complex under normal conditions but, when exposed to a UV light source such as a mercury lamp, to decompose rapidly to supply free acid and thus very rapidly solubilize the ferric ion polyvinyl alcohol complex.

While both the ferric ammonium tricitrate and the ammonium trioxalatoferrate may be employed, the ammonium trioxalatoferrate is preferred because it has greater solubility.

Preferably the diol that is employed is 1,4-butanediol and the inorganic ferric salt preferably employed is ferric nitrate.

The solid content of these compositions is in general from 3—7% by weight.

A particularly desirable composition contains per hundred grams of 88% hydrolized polyvinyl alcohol about 80 to 200 grams of 1,4-butanediol, about 35 to 125 grams of ammonium trioxalatoferrate, about 30 to 100 grams of ferric nitrate and about 1,000 to 5,000 milliliters of water.

The positive-working photoresist compositions of this aspect of the invention are particularly useful in the production of color CRT screen structures, for example the black light-absorbing matrix, by a method which may involve depositing a layer of such a photoresist composition on the inner surface of a viewing panel of a glass CRT envelope, exposing the photoresist layer through a shadow mask, depositing on the exposed photoresist layer an opaque graphite layer from an aqueous graphite dispersion and then developing the superimposed layers with water to remove the graphite layer associated with the exposed layers of the photoresist layer from the viewing panel.

However these compositions may be used for other purposes, for example in the production of printed circuits, for photoetching and for many other purposes.

Other objects of the invention are considered to be met by another aspect of the invention wherein there is provided a pigmented positive-working photoresist composition that is particularly adapted for the production of a black, light-absorbing matrix on a colour CRT screen and by a novel method of employing this pigmented composition for the production of such a black light-absorbing matrix.

This novel composition comprises the previously described positive-working photoresist composition of the invention pigmented with a finely divided black pigment.

This black pigmented positive-working photoresist composition of the invention is particularly adapted for the formation of a black light-absorbing matrix in a colour picture tube screen as it presents the advantages in not only eliminating the use of the hazardous ammonium hexachromate and hydrogen peroxide or hydrazide solutions but also provides the advantages of allowing elimination of some of the steps previously required for formation of the light-absorbing matrix.

As the black pigment there is generally employed finely divided graphite or lampblack, the graphite employed generally having an average particle size of 0.8—1.3 µm and the lamp-black an average particle size of about 70—100 nm.

Preferably the solid content of the pigmented composition is about 3%—7% by weight.

Particularly useful pigmented compositions are those comprising a 3% to 7% volume mixture in water of about 1 mole of approximately 88% hydrolyzed polyvinyl alcohol, about 0.5—1.5 moles of 1,4-butanediol, about 0.5—1.5 moles of ammonium trioxalatoferrate, about 0.05—0.07 mole of ferric nitrate and about 3—12 moles of finely divided graphite or lamp-black.

It is preferred that the polyvinyl alcohol have a molecular weight within the range of about 40,000—175,000.

According to another aspect of the invention the pigmented photoresist composition of the invention may be employed to form a black, light-absorbing matrix for separating light luminescing areas on a colour

**0 091 163**

CRT screen in the following manner. A thin aqueous layer of the pigmented photoresist composition is provided on the inner surface of the viewing panel of a CRT envelope. This aqueous layer is dried at room temperature for about 15 to 180 seconds in order to remove some of the water and cause the thin layer to become immobile. Thereafter this layer is exposed to ultraviolet radiation beamed through multiple openings of a pattern mask located in a position spaced from the layer in order to cause these areas designated for coating by phosphors to become water soluble. Most frequently the layer is sequentially exposed three times; the position of the light source for each exposure positioned to substantially correspond to that of the subsequently placed electron gun used to excite the desired color pattern in the finished tube. The exposed layer is then heated at 35°C to 49°C (95—120°F) for about 1 to 3 minutes to remove the remainder of the water and cause the unexposed areas of the layer to become water insoluble. The exposed portions of the layer are then removed by development with water.

As a result the surface of the viewing panel is provided with a black light-absorbing matrix surrounding areas of the surface suitable for formation into light luminescing areas by providing these areas with cathodo luminescent phosphors by means well known in the art.

The invention will now be described in greater detail with reference to the following examples:

I. Non-pigmented photoresist composition

A non-pigmented photoresist component was prepared by mixing the following ingredients.

| | |
|---|---|
| Polyvinyl alcohol 523 (5.65% aqueous solution of 88% hydrolyzed polyvinyl alcohol of molecular weight of 40,000—175,000 | 3000 ml |
| 1,4-Butanediol | 150 ml |
| Deionized water | 7940 ml |
| 0.1 Molar ammonium trioxalatoferrate | 2310 ml |
| 0.1 Molar ferric nitrate Fe(NO$_3$)$_3$ . 9H$_2$O | 1500 ml |

The resultant composition was deposited on a surface of a glass panel to produce a layer with a thickness of about 10 µm.

The coated panel was then spun at room temperature for about 1—2 minutes to remove a sufficient amount of the water to cause the layer to become immobile.

The layer was then exposed for about 45 seconds, to ultraviolet radiation of 365 nm from a 100 watt light source through a shadow mask having apertures of about 6—10 mils.

The exposed layer was then dried at 38°C (100°F) for about 1 minute. The resultant dried layer with a thickness of about 0.5—1.0 µm was then developed by washing with water.

As a result, a pattern of clear transparent windows surrounded by a 0.7 µm thick network of hard, water-insoluble, polymerized polyvinyl alcohol was formed on the panel, each window having a diameter of about 0.15—0.25 µm (6—10 mils) and corresponding to an aperture of the shadow mask.

II. Pigmented photoresist composition

A black pigmented photoresist composition was prepared by mixing the following ingredients.

| | |
|---|---|
| Polyvinyl alcohol 523 | 200 ml |
| 0.7M Ammonium trioxalatoferrate | 66 ml |
| 0.35M Ferric nitrate Fe(NO$_3$)$_3$ . 9H$_2$O | 86 ml |
| 10% 1,4-Butanediol | 260 ml |
| Graphite dispersion (12% solids—average particle size 0.8—1.3 µm) | 180 ml |

The resultant composition was deposited on the inner surface of the glass face panel of a cathode ray tube envelope.

The envelope was then spun at room temperature for about 3 minutes to remove a sufficient amount of water to cause the deposited layer to become immobile.

A shadow mask, similar to that previously employed, was affixed to the viewing panel in a position spaced from the deposited layer on the inner surface thereof. The layer was then exposed, through the mask, to a light source similar to that previously employed, for a period of about 1 minute.

The position of the light source substantially corresponded with that of a subsequently placed electron gun employed to excite one of the primary color luminescing phosphor layers employed in the finished tube.

The light source was moved to two other positions corresponding with the positions corresponding with the two other subsequently placed electron guns used to excite the other two primary color luminescing phosphor layers employed in the finished tube. Exposure of the layer from these two additional positions was carried out in an identical manner.

The exposed layer was then dried at about 38°C (100°F) for about 3 minutes. The resultant hardened

4

**0 091 163**

black opaque layer of about 1—1.5 µm thickness was thus developed by washing with water at room temperature.

As a result, the exposed portions of the layer were removed, leaving a black light-absorbing matrix surrounding clear window areas, each window area corresponding essentially to an aperture of shadow mask and being suitable for coating by primary light cathode luminescing phosphors by means well known in the art.

It will be apparent that various modifications may be made to the present invention without departing from its scope as defined in the following claims.

**Claims**

1. A positive-working photoresist composition comprising a mixture in water of an organic ferric salt selected from the group consisting of ammonium trioxalatoferrate and ferric ammonium tricitrate, and an inorganic ferric salt, characterized in that it comprises furthermore a diol selected from the group consisting of 1,4-butanediol, 1,5-pentanediol and 1,4-pentanediol and 85—99% hydrolyzed polyvinyl alcohol and that the inorganic ferric salt is selected from the group consisting of ferric nitrate and ferric sulfate.

2. The positive-working photoresist composition of Claim 1 wherein the organic ferric salt is ammonium trioxalatoferrate, the inorganic ferric salt is ferric nitrate and the diol is 1,4-butanediol.

3. The positive-working photoresist composition of Claim 2 wherein per 100 grams of 88% hydrolyzed polyvinyl alcohol there is present about 80—200 grams of 1,4-butanediol, about 35—125 grams of ammonium trioxalatoferrate, about 30—100 grams of ferric nitrate and about 1000—5000 milliliters of water.

4. The positive-working resist composition of Claim 2 wherein there is present per 1000 ml of composition about 17—18 grams of polyvinyl alcohol, about 15—16 ml of 1,4-butanediol, about 9—10 grams of ammonium trioxalatoferrate, and about 7—8 grams of ferric nitrate.

5. The positive working photoresist composition of Claims 1—4 characterized in that it comprises a finely divided black pigment.

6. The photoresist composition of Claim 5 wherein the finely divided black pigment is selected from the group consisting of finely divided graphite and lampblack.

7. The photoresist composition of Claim 6 wherein the solid content of the composition is 3%—7% by volume.

8. The positive-working photoresist composition according to Claims 1—7 comprising in the 3%—7% by volume mixture in water about 1 mole of approximately 88% hydrolyzed polyvinyl alcohol, about 0.5—1.5 moles of 1,4-butanediol, about 0.5—1.5 moles of ammonium trioxalatoferrate, about 0.05—0.07 mole of ferric nitrate and about 3—12 moles of the finely divided black pigment selected from the group consisting of finely divided graphite and lampblack.

9. The positive-working photoresist composition of Claim 8, wherein the polyvinyl alcohol has a molecular weight of from 40,000—175,000.

10. The positive-working photoresist composition of Claim 9 wherein finely divided graphite of an average particle size of 0.8—1.3 µm is employed.

11. The photoresist composition of Claim 9 wherein lampblack of an average particle size of 70—100 nm is employed.

12. A method of providing a color cathode ray tube screen including a viewing panel and discrete color luminescing areas responsive to electron excitation positioned on the inner surface of said viewing panel with a black, light-absorbing matrix separating said color luminescing areas, said method comprising the steps of:

a) providing on a surface of the inner surface of the viewing panel of a glass cathode ray tube envelope a thin aqueous layer of a positive-working photoresist composition according to Claims 1—11 comprising a 3—7% by volume mixture in water of about 1 mole of approximately 85—99% hydrolyzed polyvinyl alcohol, about 0.5—1.5 moles of 1,4-butanediol, about 0.5—1.5 moles of ammonium trioxalatoferrate, about 0.05—0.07 mole of ferric nitrate and about 3—12 moles of finely divided graphite or lampblack;

b) drying said thin aqueous layer at room temperature for about 15—180 seconds to cause said thin layer to become immobile;

c) exposing areas of said thin layer corresponding to said color luminescing areas to ultra-violet radiation for a time sufficient to cause said exposed areas to become water soluble;

d) heating said thin layer at a temperature of about 35—49°C for about 1—3 minutes to thereby remove the remainder of water from said thin layer matrix and render water-insoluble the unexposed areas of said layer;

e) removing the exposed portions of said layer from said surface by developing said layer with water, thereby providing said surface with a black, light absorbing, matrix surrounding areas of said surface suitable for coating by phosphors for forming said color luminescing areas.

13. The method of Claim 12 wherein the polyvinyl alcohol is 88% hydrolyzed polyvinyl alcohol of a molecular weight of 40,000—175,000.

5

**0 091 163**

14. The method of Claim 13 wherein finely divided graphite of an average particle size of 0.8—1.3 μm is employed.

15. The method of Claim 13 wherein lampblack of an average particle size of 70—100 nm is employed.

16. Use of the positive-working photoresist composition of Claims 1—11 for the formation of a black light-absorbing matrix on a color picture tube screen.


**Patentansprüche**

1. Positiv arbeitende Photoresistmasse mit einem Gemisch aus Wasser und einem organischen Ferrisalz aus der Gruppe, die aus Ammoniumtrioxalatferrat und Ferriammoniumtricitrat besteht, und einem anorganischen Ferrisalz, dadurch gekennzeichnet, dass die Masse weiterhin ein Diol aufweist aus der Gruppe, die aus 1,4-Butandiol, 1,5-Pentandiol und 1,4-Pentandiol und 85—99% hydrolisiertem Polyvinylalkohol besteht und dass der anorganische Ferrisalz aus der Gruppe gewählt ist, die aus Ferrinitrat und Ferrisulfat besteht.

2. Positiv arbeitende Photoresistmasse nach Anspruch 1, in welche der organische Ferrisalz Ammoniumtrioxalatferrat ist, der anorganische Ferrisalz Ferrinitrat ist und dass das Diol 1,4-Butandiol ist.

3. Positiv arbeitende Photoresistmasse nach Anspruch 2, in welche es je 100 g 88% hydrolysierten Polyvinylalkohols etwa 80—200 g 1,4-Butandiol, etwa 35—125 g Ammoniumtrioxalatferrat, etwa 30—100 g Ferrinitrat und etwa 1000—5000 ml Wasser gibt.

4. Positiv arbeitende Resistmasse nach Anspruch 2, in welche es je 1000 ml Masse etwa 17—18 g Polyvinylalkohol, 15—16 ml 1,4-Butandiol, etwa 9—10 g Ammoniumtrioxalatferrat und etwa 7—8 g Ferrinitrat gibt.

5. Positiv arbeitende Photoresistmasse nach den Ansprüchen 1—4, dadurch gekennzeichnet, dass die Masse ein feinverteiltes schwarzes Pigment aufweist.

6. Photorsistmasse nach Anspruch 5, in welche das feinverteilte schwarze Pigment aus der Gruppe gewählt ist, die aus feinverteiltem Graphit und Lampenschwarz besteht.

7. Photoresistmasse nach Anspruch 6, in welche der Festgehalt der Masse 3—7 Volumenprozent beträgt.

8. Positiv arbeitende Photoresistmasse nach den Ansprüchen 1—7 mit 1 Mol etwa 88% hydrolysierten Polyvinylalkohols, etwa 0.5—1.5 Mol 1,4-Butandiol, etwa 0.5—1.5 Mol Ammoniumtrioxalatferrat, etwa 0.05—0.07 Mol Ferrinitrat und etwa 3—12 Mol des feinverteilten schwarzen Pigments aus der Gruppe, die aus feinverteiltem Graphit und Lampenschwarz besteht, in dem 3—7 Volumenprozent-Gemisch mit Wasser.

9. Positiv arbeitende Photoresistmasse nach Anspruch 8, in welche der Polyvinylalkohol ein Molekulargewicht von etwa 40.000—175.000 aufweist.

10. Positiv arbeitende Photoresistmasse nach Anspruch 9, in welche feinverteiltes Graphit mit einer mittleren Teilchengrösse von 0.8—1.3 μm verwendet wird.

11. Photoresistmasse nach Anspruch 9, in welche Lampenschwarz mit einer mittleren Teilchengrösse von 70—100 nm verwendet wird.

12. Verfahren zum Herstellen eines Schirms einer Farbelektronenstrahlröhre mit einer Wiedergabeplatte und diskreten farbig aufleuchtenden Gebieten, die auf Elektronenanregung reagieren auf der inneren Oberfläche der genannten Wiedergabeplatte mit einer schwarzen, lichtabsorbierenden Matrix, welche die genannten farbig aufleuchtenden Gebiete voneinander trennt, wobei dieses Verfahren die folgenden Schritte aufweist:

a) das auf einer Oberfläche der inneren Oberfläche der Widergabeplatte einer Hülle einer aus Glas bestehenden Elektronenstrahlröhre Anbringen einer dünnen wässrigen Schicht einer positiv arbeitenden Photoresistmasse nach den Ansprüchen 1—11 mit einem 3—7-volumenprozentigem Gemisch in Wasser von 1 Mol von etwa 85—99% hydrolysiertem Polyvinylalkohol, etwa 0.5—1.5 Mol von Ammoniumtrioxalatferrat, etwa 0.05—0.07 Mol von Ferrinitrat und etwa 3—12 Mol feinverteilten Graphits oder Lampenschwarzes;

b) das Trocknen der genannten dünnen wässrigen Schicht bei Raumtemperatur während 15—180 Sekunden um die genannte dünne Schicht unbeweglich zu machen;

c) das einer UV-Strahlung Aussetzen von Gebieten der genannten dünnen Schicht entsprechend den genannten farbig aufleuchtenden Gebieten und zwar während einer Zeit, die ausreicht um die genannten exponierten Gebiete wasserlöslich zu machen;

d) das Erwärmen der genannten dünnen Schicht auf einer Temperatur von etwa 35—49°C während etwa 1—3 Minuten um dadurch das restliche Wasser aus der genannten dünnen Schichtmatrix zu entfernen und die nicht-exponierten Gebiete der genannten Schicht wasserunlöslich zu machen;

e) das Entfernen der exponierten Teile der genannten Schicht von der genannten Oberfläche indem die Schicht mit Wasser bedeckt wird, wobei die genannte Oberfläche mit einer schwarzen lichtabsorbierenden Matrix versehen wird, die Gebiete der genannten Oberfläche umgibt, die geeignet sind zum Bedecken mit Leuchtstoffen zum Bilden der genannten farbig aufleuchtenden Gebiete.

13. Verfahren nach Anspruch 12, in welche der Polyvinylalkohol 88% hydrolysierter Polyvinylalkohol mit einem Molekulargewicht von 40,000—175,000 ist.

6

14. Verfahren nach Anspruch 13, in welche feinverteiltes Graphit mit einer mittleren Teilchengrösse von 0.8—1.3 μm verwendet wird.

15. Verfahren nach Anspruch 13, in welche Lampenschwarz mit einer mittleren Teilchengrösse von 70—100 nm verwendet wird.

16. Die Verwendung positiv arbeitender Photoresistmasse nach den Ansprüchen 1—11 zum Bilden einer schwarzen lichtabsorbierenden Matrix auf einem Farbbildröhrenschirm.

**Revendications**

1. Composition de photorésist à effet positif contenant un mélange aqueux d'un sel ferrique organique sélectionné dans le groupe constitué par le trioxalatoferrate d'ammonium et le tricitrate d'ammonium ferrique, et un sel ferrique inorganique, caractérisée en ce qu'elle contient en outre un diol sélectionné dans le groupe constitué par le 1,4 butanediol, le 1,5-pentanediol et 1,4-pentanediol et 85 à 99% d'alcool polyvinylique hydrolysé et que le sel ferrique inorganique est sélectionné dans le groupe constitué par le nitrate ferrique et le sulfate ferrique.

2. Composition de photorésist à effet positif selon la revendication 1, dont le sel ferrique organique est le trioxalatoferrate d'ammonium, le sel ferrique organique est le nitrate ferrique et le diol est le 1,4-butanediol.

3. Composition de photorésist à effet positif selon la revendication 2, dans laquelle, par 100 g d'alcool polyvinylique hydrolysé à 88%, est présent environ 80 à 200 g de 1,4-butanediol, environ 35 à 125 g de trioxalatoferrate d'ammonium, environ 30 à 100 g de nitrate ferrique et environ 1000 à 5000 ml d'eau.

4. Composition de résist à effet positif selon la revendication 2, contenant, par 1000 ml de composition, environ 17 à 18 g d'alcool polyvinylique, environ 15 à 16 ml de 1,4-butanediol, environ 9 à 10 g trioxalatoferrate d'ammonium et environ 7 à 8 g de nitrate ferrique.

5. Composition de photorésist à effet positif selon la revendication 1 à 4, caractérisée en ce qu'elle contient un pigment noir finement divisé.

6. Composition de photorésist selon la revendication 5, dans laquelle le pigment noir finement divisé est sélectionné dans le groupe constitué par du graphite finement divisé et du noir de lampe.

7. Composition de photorésist selon la revendication 6, dans laquelle le volume solide de la composition est de 3 à 7% en volume.

8. Composition de photorésist à effet positif selon la revendication 1 à 7, dont le mélange aqueux de 3% à 7% en volume est constitué par environ 1% en moles d'alcool polyvinylique hydrolysé à environ 88%, environ 0,5 à 1,5 mole de 1,4 butanediol, environ 0,5 à 1,5 mole de trioxalatoferrate d'ammonium, environ 0,05 à 0,07 mole de nitrate ferrique et environ 3 à 12 moles de pigment noir finement divisé sélectionné dans le groupe constitué par du graphite finement divisé et du noir de lampe.

9. Composition de photorésist à effet positif selon la revendication 8, dont l'alcool polyvinylique présente un poids moléculaire de 40.000 à 175.000.

10. Composition de photorésist à effet positif selon la revendication 9, dans laquelle est utilisé du graphite finement divisé d'une dimension moyenne des particules de 0,8 à 1,3 μm.

11. Composition de photorésist selon la revendication 9, dans laquelle est utilisé du noir de lampe d'une dimension moyenne des particules de 70 à 100 nm.

12. Procédé pour la réalisation d'un écran de tube à rayons cathodiques comportant un panneau de visualisation et des régions à luminescence colorée discrètes sensibles à l'excitation par des électrons, positionnées sur la surface intérieure dudit panneau de visualisation avec une matrice absorbant la lumière noire séparant lesdites régions à luminescence colorée, ledit procédé comprenant les étapes de:

a) application, sur une surface de la surface intérieure du panneau de visualisation d'une enveloppe en verre d'un tube à rayons cathodiques, d'une couche aqueuse mince d'une composition de photorésist à effet positif selon la revendication 1 à 11, contenant un mélange de 3 à 7% en volume dans de l'eau d'environ 1 mole d'environ 85 à 99% d'alcool polyvinylique hydrolysé, environ 0,5 à 1,5 mole de 1,4-butanediol, environ 0,5 à 1,5 mole de trioxalatoferrate d'ammonium, environ 0,05 à 0,7 mole de nitrate ferrique et environ 3 à 12 moles de graphite finement divisé ou de noir de lampe.

b) séchage de ladite couche aqueuse mince à la température ambiante normale pendant environ 15 à 180 secondes pour rendre ladite couche mince immobile;

c) exposition des régions de ladite couche mince correspondant auxdites régions à luminescence colorée à du rayonnement ultraviolet pendant une durée qui suffit pour rendre lesdites régions exposées solubles dans l'eau;

d) chauffage de ladite couche mince à une température d'environ 35 à 49°C pendant environ 1 à 3 minute(s) afin de chasser le reste de l'eau de ladite matrice de couche mince et de rendre les régions non exposées de ladite couche insolubles dans l'eau;

e) enlèvement des parties exposées de ladite couche de ladite surface par développement de ladite couche avec de l'eau de façon à munir ladite surface d'une matrice absorbant la lumière noire qui entoure les régions de ladite surface et qui convient à un recouvrement par des substances luminescentes pour la formation desdites régions à luminescence colorée.

13. Procédé selon la revendication 12, selon lequel l'alcool polyvinylique est de l'alcool polyvinylique hydrolysé à 88% d'un poids moléculaire de 40,000 à 175,000.

14. Procédé selon la revendication 13, selon lequel on utilise du graphite finement divisé d'une dimension moyenne des particules de 0,8 à 1,3 µm.

15. Procédé selon la revendication 13, selon lequel on utilise du noir de lampe d'une dimension moyenne des particules de 70 à 100 nm.

16. Application de ladite composition de photorésist à effet positif selon les revendications 1 à 11 pour la formation d'une matrice absorbant la lumière noire sur un écran d'un tube image en couleur.